# EUROPÄISCHE PATENTSCHRIFT

(11) **EP 4 641 631 B1**
(45) Veröffentlichungstag und Bekanntmachung des Hinweises auf die Patenterteilung: **08.07.2026**
(21) Anmeldenummer: 25200126.8
(22) Anmeldetag: 17.10.2023
(51) Int. Cl.: H10W 40/43

(54) **KÜHLEINRICHTUNG**
COOLING DEVICE
DISPOSITIF DE REFROIDISSEMENT

(30) Priorität: 28.10.2022 DE 102022128698
(43) Veröffentlichungstag der Anmeldung: 29.10.2025
(62) Teilanmeldung aus: 23204097.2
(73) Patentinhaber: Erwin Quarder Systemtechnik GmbH, 32339 Espelkamp (DE)
(72) Erfinder: Siewert, Georg, 35415 Pohlheim (DE); Bruns, Stefan, 49088 Osnabrück (DE); Heitbrink, Alexander, 32351 Stemwede (DE)
(74) Vertreter: Geskes, Christoph

(56) Entgegenhaltungen:
- EP-A1- 3 905 318
- EP-A2- 2 437 293
- DE-A1- 102019 003 030
- US-A- 6 111 749
- US-A1- 2016 290 728

## Beschreibung

Die vorliegende Erfindung betrifft eine (Hochleistungs-)Kühleinrichtung zum Abführen von Wärme von zu kühlenden Gegenständen, wie etwa von Leistungselektronikbauteilen. Die Erfindung betrifft des Weiteren eine Leistungselektronikeinheit, insbesondere für ein Elektrofahrzeug, mit mehreren Leistungselektronikbauteilen mit einer solchen Kühleinrichtung.

Kühleinrichtungen für Leistungselektronikbauteile, wie Leistungselektronikhalbleitermodule, müssen besonders effizient bzw. leistungsfähig sein. Bei derartigen Kühleinrichtungen mit einem Kühlkörper aus Metall oder einer Metalllegierung mit einer ebenen bzw. planen Wärmeaufnahmeseite, die im Einsatz der Kühleinrichtung zur Optimierung der Wärmeübertragung möglichst nah - ggf. unter direkter Anlage oder unter Vermittlung einer Zwischenschicht aus Wärmeleitmaterial, insbesondere Wärmeleitpaste - an einer (beispielsweise ebenfalls planen) Wärmeabgabeseite des zu kühlenden Gegenstands angeordnet werden sollte, ergibt sich häufig die Situation, dass entweder der Kühlkörper bzw. dessen ebene Wärmeaufnahmeseite gleichzeitig an mehreren zu kühlenden Gegenständen angeordnet werden muss, deren Wärmeabgabeseiten aufgrund jeweils unterschiedlicher Höhenabmessung der Gegenstände und/oder unterschiedlicher Verformung der beteiligten Komponenten aufgrund unterschiedlicher Materialien in unterschiedlichen Ebenen verlaufen, oder dass der Kühlkörper bzw. dessen Wärmeaufnahmeseite an eine nicht durchgängig eben verlaufende Wärmeabgabeseite eines einzelnen zu kühlenden Gegenstands angeordnet werden muss.

In beiden Fällen können sich bereichsweise größere, für eine effiziente Wärmeübertragung ungünstige Abstände ergeben zwischen der bzw. den Wärmeabgabeseiten des bzw. der zu kühlenden Gegenstände einerseits und der ebenen Wärmeaufnahmeseite des Kühlkörpers andererseits, was sich zu Lasten der Kühlleistung der Kühleinrichtung auswirkt.

Aus diesem Grund werden zum Teil Wärmeleitpasten vergleichsweise großer Schichtdicken eingesetzt, um die entsprechenden, andernfalls nur durch schlecht wärmeleitende Luft gefüllten Abstände zu überbrücken. Diese Lösung ist allerdings nicht optimal. Unter anderem deshalb, da die verwendbaren Wärmeleitpasten in der Regel eine geringere Wärmeleitfähigkeit aufweisen als das Metall/die Metalllegierung des Kühlkörpers.

DE 10 2019 003 030 A1 offenbart eine Vorrichtung umfassend ein Modul, das einen Halbleiterchip umfasst, und einen Kühlkörper, der mit dem Modul gekoppelt ist, und ein Substrat und eine Vielzahl von Vorsprüngen umfasst. Die Vorrichtung umfasst weiterhin eine Abdeckung, die einen Kanal einschließt, wobei die Vielzahl von Vorsprüngen des Kühlkörpers innerhalb des Kanals angeordnet ist, und einen Dichtungsmechanismus, der zwischen der Abdeckung und dem Modul angeordnet ist.

Ausgehend hiervon ist es Aufgabe der vorliegenden Erfindung, eine Kühleinrichtung bzw.- eine Leistungselektronikeinheit der eingangs genannten Art weiterzuentwickeln.

Diese Aufgabe wird gelöst durch eine Kühleinrichtung mit den Merkmalen des Anspruchs 1 und eine Leistungselektronikeinheit mit den Merkmalen des Anspruchs 20.

Eine erfindungsgemäße Kühleinrichtung verfügt dabei über ein erstes (insbesondere längliches) Hybrid-Kühlbauteil, durch das Kühlfluid durchleitbar ist und das über einen insbesondere starren, fluiddicht mit einem Grundkörper aus Kunststoff des ersten Kühlbauteils verbundenen, insbesondere plattenartigen Kühlkörper aus Metall oder einer Metalllegierung zur Anordnung an zu kühlenden Gegenständen verfügt. Weiter weist sie ein mit dem ersten Kühlbauteil insbesondere lösbar verbundenes zweites (insbesondere längliches) Hybrid-Kühlbauteil auf, durch das Kühlfluid leitbar ist und das mehrere, bevorzugt mindestens drei, Kühlbauteilabschnitte aufweist, die insbesondere über Verbindungsgelenke (paarweise) gelenkig miteinander verbunden sind. Dabei verfügen die Kühlbauteilabschnitte über jeweils einen vorzugsweise plattenartigen Kühlkörper aus Metall oder einer Metalllegierung zur Anordnung an zu kühlenden Gegenständen, der mit einem Grundkörper aus Kunststoff des zweiten Kühlbauteils fluiddicht verbunden ist, wobei die beiden Hybrid-Kühlbauteile unter Bildung eines zwischen ihnen angeordneten Aufnahmeraums für zu kühlende Gegenstände mit Abstand zueinander positioniert und miteinander insbesonderelösbar verbunden sind. Ein Rahmenteil weist mit ihm verbundene elektrische Kontaktierungselemente auf zur Kontaktierung von elektrischen Kontaktierungselementen von zu kühlenden Gegenständen und/oder von anderen elektronischen Bauteilen. Das elektrische Kontaktierungselement weist einen ersten, insbesondere an einem Ende desselben angeordneten, vorzugsweise im Rahmen der Integration in das Spritzgussteil freigelassenen Verbindungsabschnitt, mit dem es mit einem elektrischen Kontaktierungselements eines zu kühlenden Gegenstands verbindbar ist, und einen zweiten, insbesondere an einem anderen Ende des elektrischen Kontaktierungselements angeordneten, vorzugsweise im Rahmen der Integration oder Einbettung in das Spritzgussteil freigelassenen Verbindungsabschnitt, mit dem das elektrische Kontaktierungselement mit einem elektrischen Kontaktierungselement eines anderen elektronischen Bauteils elektrisch leitend verbindbar ist, auf.

Durch die Verwendung von zwei derartigen verschiedenen Hybrid-Kühlbauteilen, die unter anderem einen Aufnahmeraum für zu kühlende Gegenstände aufweisen, wie etwa für Leistungselektronikhalbleitermodule, können die zu kühlenden Gegenstände zum einen wirksam von zwei Seiten gekühlt werden. Zum anderen wird unter anderem für den Fall, dass mehrere zu kühlende Gegenstände gleichzeitig von den Hybrid-Kühlbauteilen gekühlt werden sollen, deren Wärmeabgabeseiten nicht exakt in derselben Ebene verlaufen, die Möglichkeit geschaffen, den sich daraus ergebenden Höhenversatz durch die untereinander gelenkig verbundenen Kühlbauteilabschnitte des zweiten Hybrid-Kühlbauteils auszugleichen. Denn diese gelenkige Verbindung ermöglicht es, die einzelnen Kühlbauteilabschnitte entsprechend ebenfalls in unterschiedliche Ebenen zu bewegen und einzeln an die unterschiedlich hohen Wärmeabgabeseiten anzupassen bzw. anzulegen.

Infolgedessen ist es erfindungsgemäß vorteilhafterweise zumindest nicht (mehr) notwendig, zur Überbrückung insbesondere solcher größeren Abstände Wärmeleitpaste großer Schichtdicke verwenden zu müssen, was im Ergebnis im Vergleich zu den Lösungen des Stands der Technik zu einer höheren Kühlleistung der erfindungsgemäßen Kühl-einrichtung führt. Es versteht sich, dass aber natürlich auch bei der erfindungsgemäßen Lösung weiterhin Wärmeleitpaste zwischen den vorgenannten Seiten eingesetzt werden kann, insbesondere zum Ausgleich kleinerer Toleranzen, die sich beispielsweise aus der jeweiligen Struktur der ansonsten ebenen Wärmeabgabeseiten ergeben können.

In weiterer Konkretisierung dieses Konzepts kann die Wärmeaufnahmeseite jedes Kühlkörpers jedes Kühlbauteilabschnitts des zweiten Hybrid-Kühlbauteils, die im Einsatz der Kühleinrichtung an dem jeweils zu kühlenden Gegenstand angeordnet werden soll, jeweils eine insbesondere durch die jeweilige Unterseite des jeweiligen Kühlkörpers gebildete Wärmeaufnahmefläche aufweisen, wobei die Wärmeaufnahmeflächen der einzelnen Kühlkörper dann bedarfsweise relativ zueinander in verschiedene Ebenen bewegbar sind. Bezogen auf benachbarte Kühlbauteilabschnitte des zweiten Hybrid-Kühlbauteils kann dann entsprechend die Wärmeaufnahmefläche des Kühlkörpers des jeweils einen Kühlbauteilabschnitts naturgemäß relativ zu der Wärmeaufnahmefläche des jeweils anderen Kühlbauteilabschnitts bewegt werden.

Es versteht sich, dass die Kühleinrichtung mehrere Paare von jeweils derart gelenkig miteinander verbundenen Kühlbauteilabschnitten aufweisen kann (aber nicht muss).

Beispielsweise könnten mindestens drei Kühlbauteilabschnitte bzw. zwei Paare von Kühlbauteilabschnitten vorgesehen sein mit einem mittleren Kühlbauteilabschnitt, der unter Bildung eines ersten Paares an einer ersten Seite (des mittleren Kühlbauteilabschnitts) mit einem ersten äußeren Kühlbauteilabschnitt gelenkig verbunden ist und der unter Bildung eines zweiten Paares an einer zweiten Seite (des mittleren Kühlbauteilabschnitts) mit einem zweiten äußeren Kühlbauteilabschnitt gelenkig verbunden ist.

Was das oder jedes Verbindungsgelenk betrifft, mit dem benachbarte Kühlbauteilabschnitte gelenkig verbunden sind, so kann dieses zwei voneinander beabstandete, insbesondere parallele Drehachsen aufweisen, um die die beiden Kühlbauteilabschnitte relativ zueinander in die verschiedenen Ebenen bewegbar, nämlich verschwenkbar sind.

Vorzugsweise können die Kühlkörper der Kühlbauteilabschnitte des zweiten Hybrid-Kühlbauteils jeweils mit einem gemeinsamen (länglichen) Grundkörper aus Kunststoff verbunden sein, der flexible, insbesondere biegeweiche, als insbesondere flache Hohlkörper ausgebildete Verbindungsabschnitte aufweist, die die Verbindungsgelenke zwischen benachbarten Kühlbauteilabschnitten des zweiten Hybrid-Kühlbauteils bilden und diese gleichzeitig fluidleitend miteinander verbinden, sodass durch sie Kühlmedium zwischen den benachbarten Kühlbauteilabschnitten fließen kann.

Der gemeinsame Grundkörper kann dabei im Bereich jedes Kühlbauteilabschnitts jeweils eine Vertiefung aufweisen, in die der jeweilige Kühlkörper des entsprechenden Kühlbauteilabschnitts mindestens teilweise eingesetzt ist, vorzugsweise vollständig bis auf einen seitlichen, insbesondere senkrecht von einem im Wesentlichen quaderförmigen Hauptteil des Kühlkörpers abstehenden Verbindungsrand des Kühlkörpers, mit dem der gemeinsame Grundkörper fluiddicht verbunden ist, insbesondere stoff- und/oder formschlüssig.

Was den Aufnahmeraum der Kühleinrichtung betrifft, so kann er durch das zwischen den beiden Hybrid-Kühlbauteilen angeordnete, insbesondere aus Kunststoff bestehende, vorzugsweise als Spritzgussteil ausgebildete Rahmenteil der Kühleinrichtung unterteilt sein in mehrere separate Teilaufnahmeräume für zu kühlende Gegenstände.

Jeder Teilaufnahmeraum kann dabei durch seitliche Begrenzungsstreben des Rahmenteils begrenzt sein, insbesondere durch ein Paar von sich mit Abstand gegenüberliegenden Querstreben und ein Paar von sich mit Abstand gegenüberliegenden Längsstreben.

Vorzugsweise können sich dabei benachbarte Teilaufnahmeräume dieselbe Querstrebe teilen bzw. an einer Seite durch dieselbe, zwischen den benachbarten Teilaufnahmeräumen angeordnete Querstrebe begrenzt sein, wobei jedes Verbindungsgelenk des zweiten Hybrid-Kühlbauteils mit (geringem) Abstand zu einer solchen Querstrebe ohne seitlichen Versatz neben dieser angeordnet ist, insbesondere oberhalb derselben.

In weiterer Ausbildung der Erfindung kann vorgesehen sein, dass jeder Kühlbauteilabschnitt des zweiten Hybrid-Kühlbauteils jeweils einem Teilaufnahmeraum zugeordnet ist, in den der Kühlbauteilabschnitt, insbesondere der Kühlkörper desselben, mindestens teilweise eintaucht sowie eingepasst ist. Dies insbesondere derart, dass sich mit Abstand gegenüberliegende, den jeweiligen Teilaufnahmeraum seitlich begrenzende Längsstreben des Rahmenteils jeweils benachbart, insbesondere parallel zu zugeordneten Längsseiten des Kühlbauteilabschnitts verlaufen und etwaige quer zu ihnen verlaufende Bewegungen des Kühlbauteilabschnitts begrenzen oder verhindern.

Zusätzlich oder alternativ können sich mit Abstand gegenüberliegende, den jeweiligen Teilaufnahmeraum seitlich begrenzende Querstreben des Rahmenteils jeweils benachbart, insbesondere parallel zu zugeordneten Querseiten des Kühlbauteilabschnitts verlaufen und etwaige quer zu ihnen verlaufende Bewegungen des Kühlkörpers begrenzen oder verhindern.

Was das insbesondere als Spritzgussteil ausgebildete Rahmenteil betrifft, so kann es an dem ersten Hybrid-Bauteil bevorzugt lösbar befestigt sein, vorzugsweise an dem Kühlkör-per des ersten Hybrid-Bauteils, insbesondere mittels Verschraubung.

Weiter weist erfindungsgemäß das Rahmenteil mit ihm verbundene elektrische Kontaktierungselemente (aus elektrisch leitfähigem Material (Metall oder Metalllegierung, ggf. auch beschichtet)) zur Kontaktierung von entsprechenden elektrischen Kontaktierungselementen von zu kühlenden (elektronischen) Gegenständen auf und/oder von anderen/weiteren elektronischen Bauteilen, wie etwa PCB-Bauteilen.

Die Verbindung des jeweiligen elektrischen Kontaktierungselements kann insbesondere derart ausgebildet sein, dass das Kontaktierungselement unlösbar fest in das Rahmenteil integriert ist.

Das Kontaktierungselement kann ein oder mehrere Verbindungsabschnitte aufweisen, der/die (ggf. jeweils) vorzugsweise an einem Ende des Kontaktierungselements angeordnet ist/sind und der/die verbindbar ist/sind mit einem jeweiligen elektrischen Kontaktierungselement des jeweiligen zu kühlenden Gegenstands bzw. des jeweiligen anderen/weiteren elektronischen Bauteils.

Was die Integration des jeweiligen Kontaktierungselements in das Rahmenteil betrifft, so kann diese vorzugsweise unter Freilassung eines oder mehrerer solcher Verbindungsabschnitte des Kontaktierungselements geschehen.

Das jeweilige Kontaktierungselement weist erfindungsgemäß insbesondere einen ersten, insbesondere an einem Ende desselben angeordneten, vorzugsweise im Rahmen der Integration in das Spritzgussteil freigelassenen Verbindungsabschnitt auf, mit dem es mit einem elektrischen Kontaktierungselements eines zu kühlenden Gegenstands verbindbar ist, und einen zweiten, insbesondere an einem anderen Ende des Kontaktierungselements angeordneten, vorzugsweise im Rahmen der Integration oder Einbettung in das Spritzgussteil freigelassenen Verbindungsabschnitt, mit dem das elektrische Kontaktierungselement mit einem elektrischen Kontaktierungselement eines anderen/weiteren elektronischen Bauteils elektrisch leitend verbindbar, vorzugsweise mit einem PCB-Bauteil.

Bevorzugt ist das jeweilige Kontaktierungselement im Übrigen in das Rahmenteil unlösbar integriert ist, indem es mindestens bereichsweise von dem Spritzgusskunststoff des Rahmenteils umspritzt ist, vorzugsweise unter jeweiliger Freilassung des oder der Verbindungsabschnitte.

Weiter kann der oder jeder Verbindungsabschnitt des jeweiligen Kontaktierungselements eine Press-Fit-Geometrie aufweisen. Alternativ könnte er beispielsweise auch als Lötkontakt ausgebildet sein. Beispielsweise derart, dass der Verbindungsabschnitt mit einem dazu passenden elektrischen Kontaktierungselement eines elektronischen Bauteils form- und/oder reibschlüssig und/oder stoffschlüssig elektrisch verbindbar ist.

Wenn er eine beispielsweise eine Press-Fit-Geometrie aufweist, indem der Verbindungsabschnitt in entsprechendes Kontaktierungsloch eines PCB-Bauteils gesteckt wird. Wenn er als Lötkontakt ausgebildet ist, indem er entsprechend mit dem Verbindungsabschnitt des passenden elektrischen Kontaktierungslelement des anderen elektronischen Bauteils verlötet ist.

Was das Rahmenteil betrifft, so kann es im Übrigen mindestens ein, vorzugsweise mindestens zwei, insbesondere einstückig mit ihm verbundene bzw. stoffeinteilig mit dem Rahmenteil ausgebildete Positionierhilfen zur Positionierung eines elektronischen Bauteils aufweisen, insbesondere eines PCB-Bauteils.

Die erfindungsgemäße Kühleinrichtung kann im Übrigen des Weiteren eine Spanneinrichtung aufweisen zum Verspannen des ersten Hybrid-Kühlbauteils mit dem zweiten Hybrid-Kühlbauteil, sodass die Kühlkörper der Hybrid-Kühlbauteile jeweils durch die Spanneinrichtung bewirkte Druckkräfte auf zwischen ihnen anordenbare bzw. angeordnete, zu kühlende Gegenstände aufbringen können.

Die Spanneinrichtung kann dabei ein Federbauteil umfassen, das an derjenigen Seite jedes Kühlbauteilabschnitts des zweiten Hybrid-Kühlbauteils angeordnet ist und auf diese Druckkräfte in Richtung des ersten Hybrid-Kühlbauteils aufbringt, die der Seite gegenüberliegt, an der jeweils der Kühlkörper des jeweiligen Kühlbauteilabschnitts angeordnet ist. Dieses Federbauteil kann dabei mit dem ersten Hybrid-Kühlbauteil verspannt sein. Insbesondere indem es mit dem an dem ersten Hybrid-Kühlbauteil befestigten Rahmenteil vorzugsweise lösbar befestigt ist, bevorzugt mit diesem verschraubt ist.

Das Federbauteil wiederum kann mehrere Federelemente (insbesondere Federarme) aufweisen. Insbesondere mindestens zwei Federelemente pro Kühlbauteilabschnitt, die federnd gegen die jeweilige vorgenannte Seite des jeweiligen Kühlbauteilabschnitts des zweiten Hybrid-Kühlbauteil gedrückt sind oder drückbar sind. Dies vorzugsweise derart, dass jedes Federelement, insbesondere jeweils ein freie Ende desselben, gegen einen an dieser Seite jeweils angeordneten Vorsprung oder eine dort angeordnete Erhebung drückt bzw. drückbar ist.

Jeder Kühlkörper jedes Hybrid-Kühlbauteils kann im Übrigen mit dem jeweils mit ihm fest und fluiddicht, insbesondere flüssigkeitsdicht, verbundenen Grundkörper des jeweiligen Hybrid-Kühlbauteils einen Kühlfluidraum bzw. Kühlfluidleitungen ganz oder teilweise umschließen oder nach außen hin begrenzen.

Der oder jeder Kühlkörper des ersten Hybrid-Kühlbauteils und/oder die Kühlkörper des zweiten Hybrid-Kühlbauteils können des Weiteren durch (insbesondere parallele) Kühlrippen begrenzte, in den Kühlkörper eingebrachte (beispielsweise eingefräste) Kühlfluidleitungsabschnitte aufweisen.

Das erste Hybrid-Kühlbauteil kann weiter jeweils mehrere, voneinander räumlich getrennte Kühlzonen aufweisen, die mit einem insbesondere für die beiden Hybrid-Kühlbauteile gemeinsamen Zulauf der Kühleinrichtung derart fluidleitend verbunden sind, dass die Kühlzonen des ersten Hybrid-Kühlbauteils jeweils parallel in einer Parallelströmung von Kühlmedium durchströmt werden, wenn der Kühleinrichtung über den Zulauf der Kühleinrichtung Kühlmedium zugeführt wird.

Alternativ oder zusätzlich kann vorgesehen sein, dass das zweite Hybrid-Kühlbauteil jeweils mehrere, voneinander räumlich getrennte Kühlzonen aufweist, die mit einem bzw. dem insbesondere für die beiden Hybrid-Kühlbauteile gemeinsamen Zulauf der Kühleinrichtung derart fluidleitend verbunden sind, dass diese Kühlzonen des zweiten Hybrid-Kühlbauteils jeweils nacheinander in einer Reihenströmung von Kühlmedium durchströmt werden, wenn der Kühleinrichtung über den Zulauf der Kühleinrichtung Kühlmedium zugeführt wird.

Bevorzugt können die Kühlzonen des ersten und des zweiten Hybrid-Kühlbauteils dabei derart ausgebildet und fluidleitend mit dem insbesondere gemeinsamen Zulauf der Kühleinrichtung verbunden sein, dass der Kühlmedium-Volumenstrom durch die parallel von Kühlmedium durchströmbare Kühlzonen des ersten Hybrid-Kühlbauteils mit zunehmender Entfernung der jeweiligen Kühlzone von dem Zulauf der Kühleinrichtung von Kühlzone zu Kühlzone größer wird. Dies insbesondere, um eine aufgrund der Kühlmedium-Reihenströmung in dem zweiten Hybrid-Kühlbauteil - mit zunehmender Entfernung der jeweiligen Kühlzone des zweiten Hybrid-Kühlbauteils von dem Zulauf - von Kühlzone zu Kühlzone nachlassende Kühlleistung des zweiten Hybrid-Kühlbauteils zu kompensieren.

Jedem Kühlbauteilabschnitt des zweiten Hybrid-Kühlbauteils kann bevorzugt im Übrigen eine eigene Kühlzone zugeordnet sein, die insbesondere durch einen Bereich des jeweiligen Kühlkörpers des jeweiligen Kühlbauteilabschnitts gebildet ist, in dem dieser durch (ins-besondere parallele) Kühlrippen begrenzte, in den Kühlkörper eingebrachte Kühlfluidleitungsabschnitte aufweist.

Jede der räumlich getrennten Kühlzonen des ersten Hybrid-Kühlbauteils wiederum kann durch einen Bereich des Kühlkörpers desselben gebildet sein, in dem dieser durch (insbesondere parallele) Kühlrippen begrenzte, in den Kühlkörper eingebrachte Kühlfluidleitungsabschnitte aufweist.

Was den Grundkörper des zweiten Hybrid-Kühlbauteils betrifft, so kann dieser Fluidleitungsabschnitte des zweiten Hybrid-Kühlbauteils aufweisen, die auf einer dem Aufnahme-raum zugewandten Seite desselben jeweils durch den jeweiligen Kühlkörper des zweiten Hybrid-Kühlbauteils fluiddicht verschlossen sind.

Der Grundkörper des ersten Hybrid-Kühlbauteils kann wiederum Kühlfluidleitungsabschnitte des ersten Hybrid-Kühlbauteils aufweisen, die auf einer dem Aufnahmeraum zugewandten Seite durch den Kühlkörper des ersten Hybrid-Kühlbauteils fluiddicht verschlossen sind.

Der Grundkörper des ersten Hybrid-Kühlbauteils kann darüber hinaus Fluidleitungsabschnitte des ersten Hybrid-Kühlbauteils aufweisen, die auf der von dem Aufnahmeraum abgewandten Seite durch einen weiteren, insbesondere plattenartigen, vorzugsweise starren, fluiddicht mit dem Grundkörper verbundenen Kühlkörper aus Metall oder einer Metalllegierung verschlossen sind. Vorzugsweise durch einen solchen weiteren Kühlkörper, an dem weitere zu kühlende Gegenstände zur Kühlung anordenbar bzw. angeordnet sind.

Der Zulauf der Kühleinrichtung und/oder ein Ablauf der Kühleinrichtung, durch den Kühlmedium nach Durchströmen der Kühleinrichtung, insbesondere der Kühlzonen der beiden Hybrid-Kühlbauteile, abfließen kann, kann des Weiteren einen Abschnitt umfassen, der gebildet ist durch den Grundkörper des ersten Hybrid-Kühlbauteils (bzw. einstückig mit diesem Grundkörper verbunden ist).

Der Zulauf und/oder der Ablauf können dabei auf der von dem Aufnahmeraum abgewandten Seite des Grundkörpers angeordnet sein.

Was den oder jeden Grundkörper des ersten Hybrid-Kühlbauteils und/oder den oder jeden Grundkörper des zweiten Hybrid-Kühlbauteils betrifft, so ist dieser ein Spritzgussteil aus Kunststoff.

Weitere Merkmale der vorliegenden Erfindung ergeben sich aus den beigefügten Patentansprüchen, der nachfolgenden Beschreibung bevorzugter Ausführungsbeispiele und aus den beigefügten Zeichnungen.

Darin zeigt:

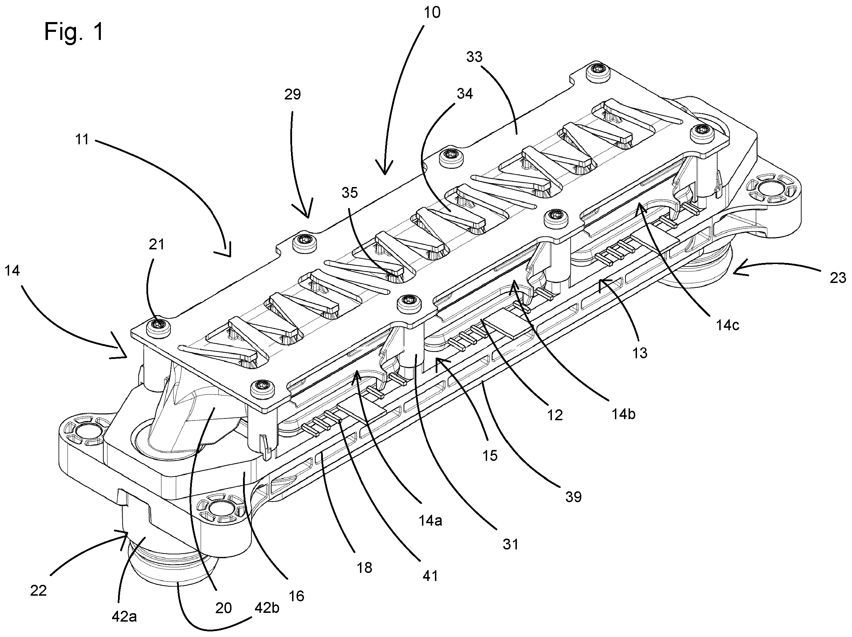

Fig. 1: eine Leistungselektronikeinheit in Schrägansicht, die eine erfindungsgemäße Kühleinrichtung mit zwei miteinander verbundenen Hybrid-Kühlbauteilen umfasst,

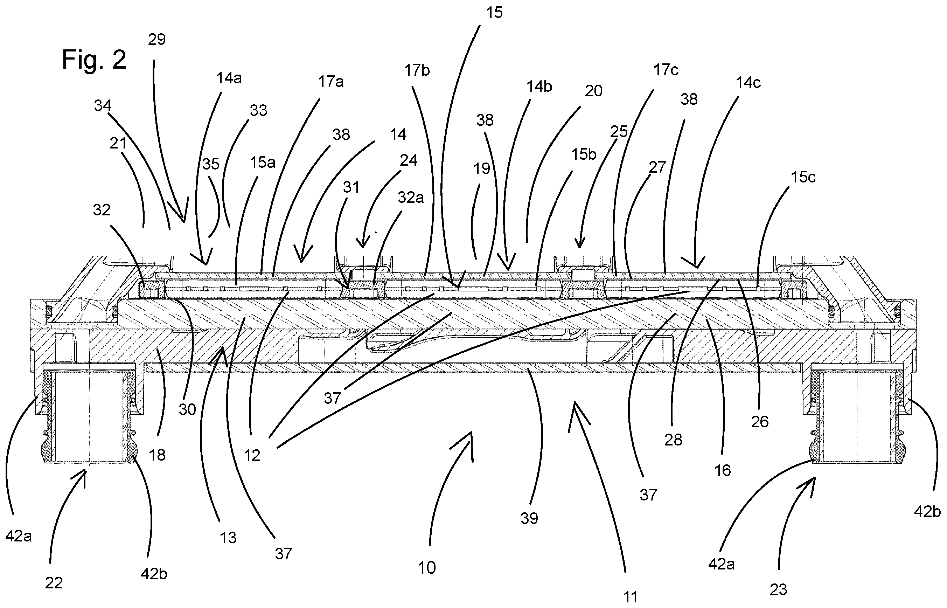

Fig. 2: die Leistungselektronikeinheit aus Fig. 1 in einem Längsschnitt,

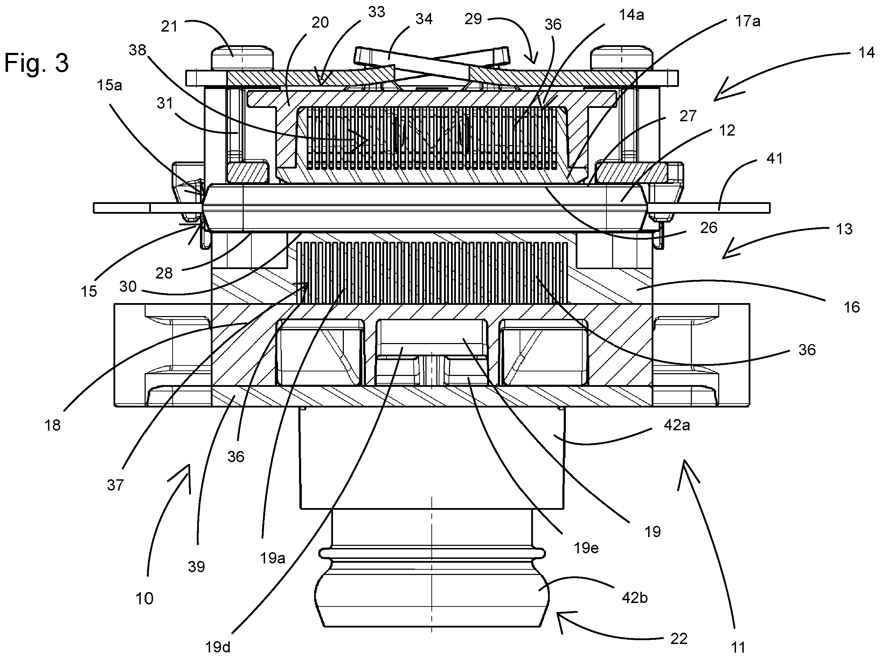

Fig. 3: die Leistungselektronikeinheit aus Fig. 1 in einem Querschnitt,

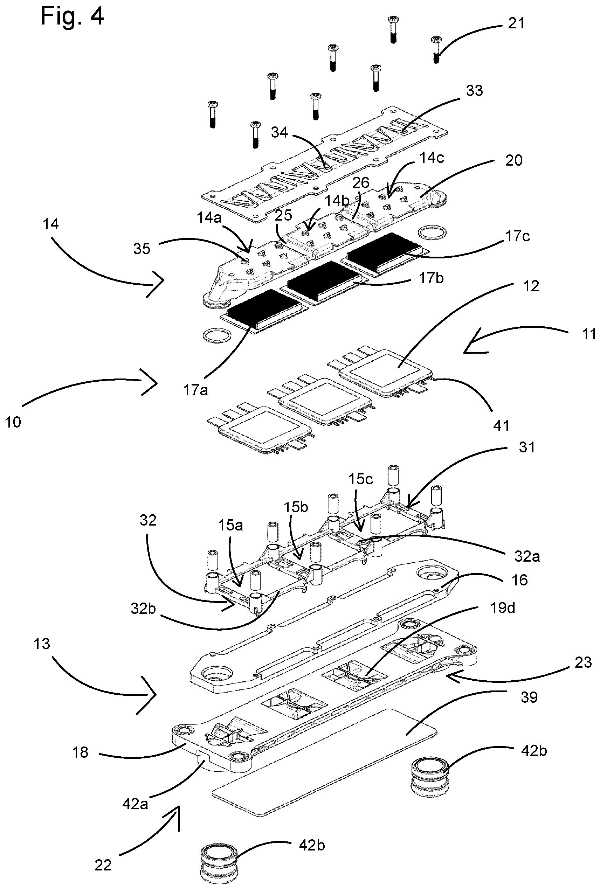

Fig. 4: eine Explosionsdarstellung der Leistungselektronikeinheit aus Fig. 1,

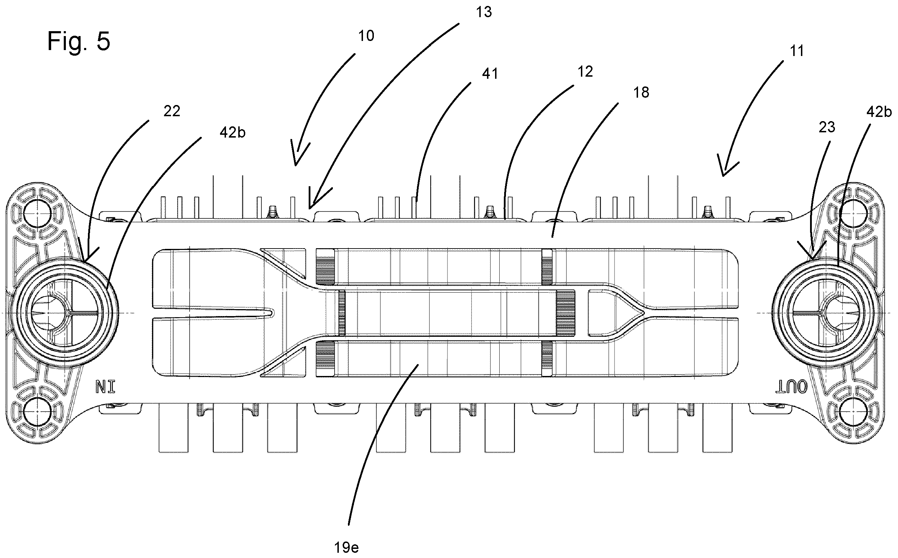

Fig. 5: die Leistungselektronikeinheit aus Fig. 1 in einer Ansicht von unten, allerdings ohne den unteren, weiteren Kühlkörper des unteren Hybrid-Kühlbauteils,
Fig. 6: ein Rahmenteil der erfindungsgemäßen Kühleinrichtung in detaillierterer Darstellung.

Die in den Figuren gezeigte Kühleinrichtung 11 dient zum Abführen von Wärme von zu kühlenden Gegenständen 12. Die Kühleinrichtung 11 ist im vorliegenden Fall Bestandteil einer Leistungselektronikeinheit 10, die als zu kühlende Gegenstände 12 Leistungselektronikbauteile aufweist, beispielsweise Leistungselektronikhalbleitermodule. Solche Leistungselektronikbauteile werden unter anderem im Zusammenhang mit Batterien bzw. Akkus von Elektrofahrzeugen verwendet.

Die Kühleinrichtung 11 verfügt über ein erstes, vorliegend unteres, längliches Hybrid-Kühlbauteil 13 mit einem länglichen, starren Kühlkörper 16 aus Metall (bspw. Aluminium) oder aus einer Metalllegierung, auf dem die zu kühlenden Gegenstände 12 angeordnet sind bzw. sitzen und das die Unterseiten der zu kühlenden Gegenstände 12 kühlt bzw. Wärme von diesen aufnimmt.

Dabei ist der starre Kühlkörper 16 mit einem vorliegend spritzgegossenen Grundkörper 18 aus Kunststoff fluiddicht verbunden und begrenzt dabei mehrere Kühlfluidleitungen 19 gemeinsam nach außen bzw. schließt sie ein, sodass durch das erste Hybrid-Kühlbauteil 13 Fluid bzw. ein Kühlmedium geleitet werden kann, wie etwa Wasser.

Die Kühleinrichtung 11 verfügt des Weiteren über ein zweites, vorliegend oberes, längliches Hybrid-Kühlbauteil 14, das einzelne, miteinander gelenkig verbundene Kühlbauteilabschnitte 14a, 14b, 14c mit jeweils starren Kühlkörpern 17a, 17b, 17c aufweist, ebenfalls aus Metall (ggf. auch Aluminium) oder einer Metalllegierung, die wiederum die Oberseiten der zu kühlenden Gegenstände 12 kühlen.

Jeder Kühlkörper 17a, 17b, 17c ist dabei in ähnlicher Weise, wie dies bei dem ersten Hybrid-Kühlbauteil 13 der Fall ist, jeweils fluiddicht mit einem vorliegend gemeinsamen (länglichen), spritzgegossenen Grundkörper 20 aus Kunststoff verbunden. Dabei schließen sie entsprechend jeweils ein oder mehrere Fluidleitungen 19 ein bzw. begrenzen sie gemein-sam nach außen, sodass auch durch das obere Hybrid-Kühlbauteil 14 Fluid bzw. Kühlmedium geleitet werden kann.

Sowohl der Kühlkörper 16 des unteren Hybrid-Kühlbauteils 13 als auch die Kühlkörper 17a, 17b, 17c des oberen Hybrid-Kühlbauteils 14 sind vorliegend jeweils als massive Körper ausgebildet.

Die beiden Hybrid-Kühlbauteile 13, 14 sind zudem mit Abstand zueinander angeordnet und miteinander lösbar verbunden, vorliegend mittels Schrauben 21 aneinander befestigt.

Dies unter Bildung eines Aufnahmeraums 15 zwischen den beiden Hybrid-Kühlbauteilen 13, 14 bzw. zwischen dem Kühlkörper 16 des unteren Hybrid-Kühlbauteils 13, insbesondere dessen (vorliegend ebener) Oberseite, und den Kühlkörpern 17a, 17b, 17c des oberen Hybrid-Kühlbauteils 14, insbesondere deren (vorliegend ebenen) Unterseiten. In dem Aufnahmeraum 15 sind die zu kühlenden Gegenstände 12 der Leistungselektronikeinheit 10 unter Anlage an diese Unter- bzw. Oberseiten angeordnet.

Beide Hybrid-Kühlbauteile 13,14 werden mit Blick auf die verwendeten Materialien als "hybrid" bezeichnet, da sie im Wesentlichen aus den sehr unterschiedlichen Materialien Metall/Metalllegierung einerseits und Kunststoff andererseits bestehen. Die im Rahmen der Erfindung notwendige fluiddichte Verbindung dieser Materialien kann dabei auf verschiedenste Art erfolgen, beispielsweise stoffschlüssig nach vorheriger Strukturierung der Verbindungsoberfläche des Metalls.

Die Kühleinrichtung 11 verfügt des Weiteren über einen Mediumeinlass bzw. Zulauf 22 sowie einen Mediumauslass bzw. Ablauf 23.

Der Zulauf 22 dient als gemeinsamer Zulauf für beide Hybrid-Kühlbauteile 13, 14, über den entsprechend sowohl dem unteren Hybrid-Kühlbauteil 13 als auch dem oberen Hybrid-Kühlbauteil 14 Kühlmedium bzw. Kühlfluid zugeführt wird, das dann die beiden Hybrid-Kühlbauteile 13 und 14 im Betrieb der Kühleinrichtung 11 durchströmt und dabei die (Ab- )Wärme abführt, die die Kühlkörper 16 bzw. 17a, 17b, 17c von den zu kühlenden Gegenständen 12 aufnehmen.

In der Regel wird es sich bei dem Kühlfluid um eine Kühlflüssigkeit handeln. Es versteht sich aber, dass es auch im Rahmen der Erfindung liegt, als Kühlfluid ein gasförmiges Medium zu verwenden. Die entsprechenden fluiddichten Verbindungen zwischen dem jeweiligen Grundkörper 18 oder 20 und den Kühlkörpern 16 bzw. 17a, 17b, 17c müssten dann entsprechend gasdicht ausgebildet sein.

Die gelenkige Verbindung der Kühlbauteilabschnitte 14a, 14b, 14c bzw. mittelbar der Kühlkörper 17a, 17b, 17c des oberen Hybrid-Kühlbauteils 14 erfolgt in besonderer Weise. Die Kühlbauteilabschnitte 14a, 14b, 14c sind dabei paarweise jeweils gelenkig miteinander verbunden, sodass sie relativ zueinander bewegbar sind. Dabei ist ein erstes Paar aus den Kühlbauteilabschnitten 14a, 14b über ein erstes Verbindungsgelenk 24 gelenkig miteinander verbunden und ein zweites Paar aus den Kühlbauteilabschnitten 14b, 14c durch ein zweites Verbindungsgelenk 25.

Jeder Kühlkörper 17a, 17b, 17c der Kühlbauteilabschnitte 14a, 14b, 14c verfügt jeweils über eine (vorliegend ebene) Unterseite, die eine (äußere) ebene bzw. plane Wärmeaufnahmefläche 26 bildet, die im Betrieb der Kühleinrichtung 11 an einer gegenüberliegenden, vorliegend ebenfalls ebenen, durch deren jeweilige Oberseite gebildete Wärmeabgabefläche 27 des jeweiligen zu kühlenden Gegenstands 12 anliegt bzw. dieser parallel gegen-überliegt, wobei ggf. zwischen der Wärmeaufnahmefläche 26 und der Wärmeabgabefläche 27 noch Wärmeleitpaste angeordnet sein kann, die unter anderem (verbleibende) geringfügige Unebenheiten der Flächen 26 und/oder 27 ausgleicht und so eine optimale Wärmeleitung zwischen diesen Flächen herstellt.

Die gelenkigen Verbindungen der Kühlbauteilabschnitte 14a, 14b, 14c ermöglichen bei Anlage bzw. Anordnung der jeweiligen Kühlbauteilabschnitte 14a, 14b, 14c an den zu kühlenden Gegenständen 12 einen besonderen Toleranzausgleich, wie nachfolgend noch näher ausgeführt wird.

Konkret können hierdurch beispielsweise auch etwas größere Unterschiede in den Höhenabmessungen der einzelnen zu kühlenden Gegenstände 12 ausgeglichen werden, deren Ausgleich etwa mittels Wärmeleitpaste aufgrund der hierfür notwendigen Schichtdicken mit Blick auf eine möglichst optimierte Wärmeleitung (zu) nachteilig wäre.

In einem solchen Fall größerer Höhenunterschiede (aber auch in anderen sinnvollen Fällen) können dann die einzelnen ebenen Wärmeaufnahmeflächen 26 der jeweiligen Kühlbauteilabschnitte 14a, 14b, 14c bzw. der oberen Kühlkörper 17a, 17b, 17c in verschiedene Ebenen bewegt werden, sodass sie dann trotz nicht in einer gemeinsamen Ebene verlaufender Wärmeabgabeflächen 27 der zu kühlenden Gegenstände 12 dennoch jeweils ohne oder nur mit geringstmöglichem Abstand der ihnen jeweils zugeordneten (ebenen) Wärmeabgabefläche 27 des jeweiligen zu kühlenden Gegenstands 12 unmittelbar gegenüber-liegen.

Die hierfür notwendige Beweglichkeit zwischen den einzelnen Kühlbauteilabschnitte 14a, 14b, 14c bzw. den einzelnen Kühlkörpern 17a, 17b, 17c wird, wie oben bereits angedeutet, durch die Verbindungsgelenke 24 bzw. 25 ermöglicht.

Wenn beispielsweise einer der zu kühlenden Gegenstände 12 eine größere Höhe aufweist als die anderen beiden zu kühlenden Gegenstände 12, verläuft dessen Wärmeabgabefläche 27 in einer anderen (höheren) Ebene als die Wärmeabgabeflächen 27 der anderen beiden zu kühlenden Gegenstände 12.

Um dies auszugleichen, wird dann das zweite Hybrid-Kühlbauteil 14 im Vergleich zu einer Situation, in der sämtliche Wärmeaufnahmeflächen 26 des zweiten Hybrid-Kühlbauteils 14 bzw. der Kühlkörper 17a, 17b, 17c in einer gemeinsamen Ebene liegen, durch Aufbringen von Druck auf den jeweiligen Kühlbauteilabschnitt 14a, 14b, 14c bzw. mittelbar auf die Kühlkörper 17a, 17b, 17c verformt.

Konkret wirken diese Kräfte auf die einzelnen Kühlkörper 17a, 17b, 17c ein und sorgen insbesondere für eine geeignete, den oben genannten Höhenunterschied ausgleichende Relativbewegung zwischen den Kühlkörpern 17a, 17b, 17c. So wird eine entsprechende Ausrichtung bzw. Bewegung der einzelnen Kühlkörper 17a, 17b, 17c derart ermöglicht, dass anschließend alle Wärmeaufnahmeflächen 26 der Kühlkörper 17a, 17b, 17c jeweils an der ihnen zugeordneten bzw. gegenüberliegenden oberen Wärmeabgabefläche 27 des ihnen jeweils zugeordneten zu kühlenden Gegenstands 12 anliegen.

Durch die Verbindung des unteren und des oberen Hybrid-Kühlbauteils 13, 14 miteinander wirken im Übrigen gleichzeitig (Gegen-)Druckkräfte des Kühlköpers 16 des unteren Hybrid-kühlbauteils 14 auf untere Wärmeabgabeflächen 28 der zu kühlenden Gegenstände 12, die den oberen Wärmeabgabeflächen 27 gegenüberliegen, sodass auch eine bzw. die (obere) Wärmeaufnahmefläche 30 des unteren Hybrid-Kühlbauteils 13 und die jeweils gegenüberliegende untere Wärmeabgabefläche 28 des jeweiligen zu kühlenden Gegenstands 12 für eine Wärmeübertragung optimal eng/dicht aneinanderliegen.

Im vorliegenden Fall werden die Verbindungsgelenke 24, 25 durch zwischen benachbarten Kühlbauteilabschnitten 14a, 14b, 14c angeordnete Zwischenabschnitte des Kunststoff-Grundkörpers 20 gebildet, mit dem jeder Kühlkörper 17a, 17b, 17c fluiddicht verbunden ist.

Die Verbindungsgelenke 24, 25 sind dabei vorliegend flexible, insbesondere biegeweiche, sowie flache, einen Kühlfluidleitungsabschnitt umschließende Hohlkörper ausgebildete Verbindungs- oder Zwischenabschnitte, die im vorliegenden Fall Bestandteil des Grund-körpers 20 sind (jeweils stoffeinteilig mit diesem ausgebildet bzw. einstückig mit diesem verbunden), die die benachbarten Kühlbauteilabschnitte 14a, 14b, 14c des zweiten Hybrid-Kühlbauteils 14 entsprechend fluidleitend miteinander verbinden, sodass durch sie Kühl-medium zwischen den benachbarten Kühlbauteilabschnitten 14a, 14b, 14c fließen kann.

Die Verbindungsgelenke 24, 25 bzw. Zwischenabschnitte verfügen dabei über eine geringere Höhe bzw. Dicke als die Bereiche des Grundkörpers 20, die jeweils gemeinsam mit dem jeweiligen Kühlkörper 17a, 17b, 17c die Kühlbauteilabschnitte 14a, 14b, 14c bilden.

Die Kräfte, mit denen die Kühlbauteilabschnitte 14a, 14b, 14c bzw. deren Kühlkörper 17a, 17b, 17c jeweils in Richtung der oberen Wärmeabgabeflächen 27 der zu kühlenden Gegenstände 12 gedrückt werden bzw. der Kühlkörper 16 die Wärmeaufnahmefläche 30 des unteren Hybrid-Kühlbauteils 13 in Richtung der unteren Wärmeabgabeflächen 28 der zu kühlenden Gegenstände 12, werden von einer Spanneinrichtung 29 aufgebracht, wie weiter unten noch näher erläutert werden wird.

Was zunächst den oben erwähnten Aufnahmeraum 15 der Kühleinrichtung 11 betrifft, in dem die zu kühlenden Gegenstände 12 sitzen, so ist er in Längsrichtung im vorliegenden Fall durch ein zwischen den beiden Hybrid-Kühlbauteilen 13, 14 angeordnetes, vorliegend als Spritzgusskunststoffbauteil ausgebildetes Rahmenteil 31 unterteilt in mehrere separate Teilaufnahmeräume 15a, 15b, 15c für die zu kühlenden Gegenstände 12. Dabei sitzt je-weils ein zu kühlender Gegenstand 12 in einem ihm zugeordneten Teilaufnahmeraum 15a, 15b bzw. 15c. Jeder Kühlbauteilabschnitt 14a, 14b, 14c des oberen Hybrid-Kühlbauteils 14, insbesondere der jeweilige Kühlkörper 17a, 17b, 17c desselben, taucht mindestens teilweise in den ihm zugeordneten Teilaufnahmeraum 15a, 15b, 15c ein und ist in diesen positionsgenau eingepasst.

Jeder Teilaufnahmeraum 15a, 15b, 15c ist dabei durch seitliche Begrenzungsstreben 32 des Rahmenteils 31 begrenzt, die jeweils nur mit geringem Abstand seitlich (außen) neben der entsprechenden Längsseite bzw. Querseite des zugeordneten Kühlbauteilabschnitts 14a, 14b, 14c angeordnet sind.

Bei den Begrenzungsstreben 32 jedes Teilaufnahmeraums 15a, 15b, 15c handelt es sich jeweils um ein Paar von sich mit Abstand gegenüberliegenden Querstreben 32a sowie um ein Paar von sich mit Abstand gegenüberliegenden Längsstreben 32b.

Benachbarte Teilaufnahmeräume 15a, 15b, 15c teilen sich dieselbe Querstrebe 32a bzw. sind an einer Seite durch dieselbe zwischen den benachbarten Teilaufnahmeräumen 15a, 15b, 15c angeordnete Querstrebe 32a begrenzt, wobei jedes Verbindungsgelenk des oberen Hybrid-Kühlbauteils 14 vorliegend mit etwas Abstand und ohne seitlichen Versatz direkt oberhalb der jeweiligen Querstrebe 32a angeordnet ist.

Die sich mit Abstand gegenüberliegenden, den jeweiligen Teilaufnahmeraum 15a, 15b, 15c seitlich begrenzenden Längsstreben 32b des Rahmenteils 31 verlaufen jeweils benachbart und parallel zu zugeordneten Längsseiten des jeweiligen zugeordneten Kühlbauteilabschnitts 14a, 14b, 14c und begrenzen oder verhindern etwaige quer zu ihnen verlaufende Bewegungen des jeweiligen Kühlbauteilabschnitts 14a, 14b, 14c.

Die sich mit Abstand gegenüberliegenden, den jeweiligen Teilaufnahmeraum 15a, 15b, 15c seitlich begrenzenden Querstreben 32a des Rahmenteils 31 wiederum verlaufen jeweils benachbart parallel zu zugeordneten Querseiten des jeweiligen Kühlbauteilabschnitts 14a, 14b, 14c und begrenzen oder verhindern etwaige quer zu ihnen verlaufende Bewegungen des Kühlbauteilabschnitts 14a, 14b, 14c.

Das Rahmenteil 31 ist im Übrigen an dem unteren Hybrid-Kühlbauteil 13 mittels Schrauben 21 lösbar befestigt, die in dessen Kühlkörper 16 eingeschraubt sind.

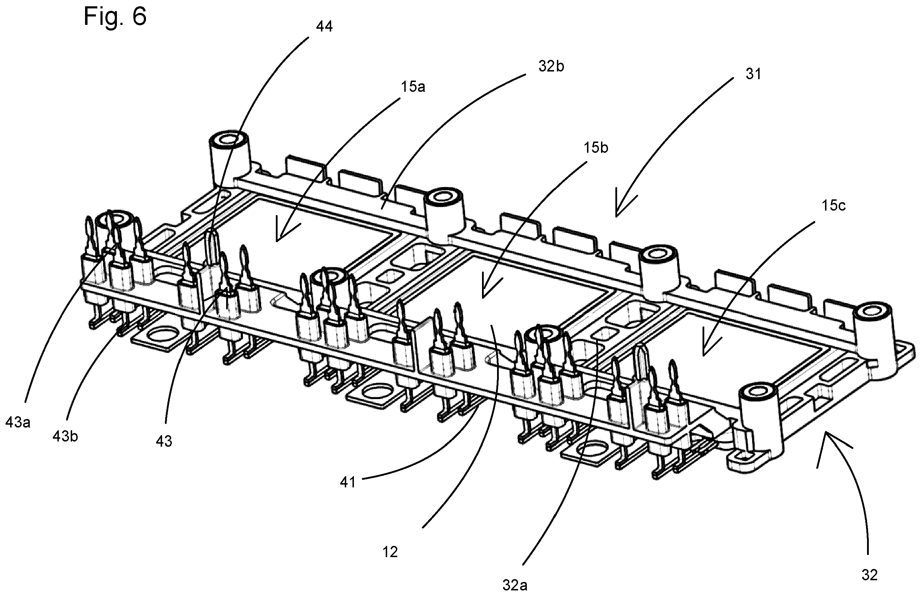

Das Rahmenteil 31 verfügt (nur in Fig. 6 gezeigt) des Weiteren über mit ihm verbundene bzw. an ihm befestigte elektrische Kontaktierungselemente 43 aus Metall.

Die Kontaktierungselemente 43 sind vorliegend in das als Spritzgussteil ausgebildete Rahmenteil 31 fest integriert, indem sie von dem Spritzgusskunststoff desselben unter Bildung einer insbesondere stoffschlüssigen Verbindung desselben bereichsweise umspritzt sind (sie bilden im Spritzgießprozess des Rahmenteils Einlegeteile).

Dabei sind jeweils an entgegengesetzten (freien) Enden angeordnete Verbindungsabschnitte 43a bzw. 43b nicht umspritzt bzw. freigelassen.

Die (oberen) Verbindungsabschnitte 43a können beispielsweise wie dargestellt als Press-Fit-Abschnitte ausgebildet sein bzw. eine Press-Fit-Geometrie aufweisen, sodass sie jeweils in einfacher Weise mit jeweils einem nicht gezeigten Kontaktierungselement eines weiteren elektronischen Bauteils elektrisch leitend verbindbar sind.

Beispielsweise kann die Leistungselektronikeinheit 10 eine (nicht gezeigte) Leiterplatte bzw. ein PCB aufweisen, mit der die zu kühlenden Gegenstände 12 (Leistungselektronikhalbleitermodule) jeweils elektrisch verbunden werden (sowohl für Steuerungsaufgaben als auch für die Energieversorgung).

Zu diesem Zweck kann jeder Verbindungsabschnitt 43a dann in ein entsprechendes Kontaktierungsloch (mit entsprechendem metallischem Kontakt) der Leiterplatte bzw. des PCB eingesteckt bzw. eingepresst werden.

Alternativ könnten die (oberen) Verbindungsabschnitte 43a aber auch als Lötkontakte ausgebildet sein, sodass diese mit der Leiterplatte entsprechend verlötet werden würden.

Jeder der unteren Verbindungsabschnitte 43b kann dann jeweils mit einem der Kontaktierungselemente 41 des entsprechenden zu kühlenden Gegenstands 12 elektrisch leitend verbunden sein, beispielsweise mit diesem verschweißt sein.

Sobald/Da das Rahmenteil 31 an der Kühleinrichtung 11 bzw. vorliegend an dem oberen Kühlkörper 16 des unteren Hybrid-Kühlbauteils 13 fixiert ist, sind entsprechend die Kontaktierungselemente 43 in ihrer Position in alle Richtung fest fixiert. Erfindungsgemäß können daher im Rahmen der Montage der Leistungselektronikeinheit 10 die zu kühlenden Gegenstände 12 während des vorstehend beschriebenen Schweißvorgangs jeweils bereits innerhalb der Teilaufnahmeräume 15a-c des bereits an dem unteren Hybrid-Kühlbauteil 13 fixierten Rahmenteils 31 positioniert werden und dort durch die Begrenzungsstreben 32 in zwei Bewegungsrichtungen weitgehend fixiert bzw. zumindest in etwaigen Bewegungen begrenzt werden, sodass positionsgenau verschweißt werden kann.

Das Rahmenteil 31 verfügt im Übrigen des Weiteren über zwei stoffeinteilig mit ihm ausgebildete bzw. einstückig mit ihm verbundene, sich vorliegend nach oben erstreckende Positionierhilfen 44, in die bei der Montage der Leistungselektronikeinheit 10 beispielsweise passende Führungslöcher des PCBs eingreifen können, um auf diese Weise auch eine exakte Positionierung des PCBs relativ zu den anderen Bauteilen zu gewährleiten.

Die Positionierhilfen 44 sind vorliegend jeweils als (sich nach oben erstreckendes) längliches Positionierstück bzw. Positionierpin ausgebildet.

Wie oben bereits erwähnt ist das untere Hybrid-Kühlbauteil 13 mit dem oberen Hybrid-Kühlbauteil 14 durch die Spanneinrichtung 29 verspannt, sodass die Kühlkörper 16, 17a, 17b, 17c der Hybrid-Kühlbauteile 13, 14 jeweils durch die Spanneinrichtung 29 bewirkte Druckkräfte auf die zwischen die ihnen, nämlich im Aufnahmeraum 15 angeordneten zu kühlenden Gegenstände 12 aufbringen.

Die Spanneinrichtung 29 umfasst dabei ein flächiges Federbauteil 33 mit einzelnen Federelementen bzw. vorliegend Federarmen 34, das vorliegend das oberste bzw. ein außen liegendes Bauteil der Kühleinrichtung 11 bildet und (außen) an derjenigen (Außen-)Seite jedes Kühlbauteilabschnitts 14a, 14b, 14c des oberen Hybrid-Kühlbauteils 14 angeordnet ist und auf diese Druckkräfte in Richtung des unteren Hybrid-Kühlbauteils 13 aufbringt. Dieses Federbauteil 33 ist dem unteren, vorliegend ebenfalls einen Teil der Spanneinrichtung 29 bildenden Hybrid-Kühlbauteil 13 verspannt, indem es seinerseits mit dem mit dem unteren Hybrid-Kühlbauteil 13 verschraubten Rahmenteil 31 verschraubt ist.

Das Federbauteil 33 wiederum kann mehrere Federarme 34 mit jeweils freiem Ende aufweisen. Vorliegend sind dies jeweils drei Federarme 34 pro Kühlbauteilabschnitt 14a, 14b, 14c, die federnd gegen die jeweilige vorgenannte (Außen-)Seite des jeweiligen Kühlbauteilabschnitts 14a, 14b, 14c des oberen Hybrid-Kühlbauteils 14 gedrückt sind. Dies derart, dass unter anderem jedes freie Ende jedes Federarms 34 gegen einen an dieser Seite je-weils angeordneten Vorsprung bzw. eine dort angeordnete Erhebung 35 drückt.

Wie oben bereits angedeutet umschließt jeder Kühlkörper 16, 17a, 17b, 17c jedes Hybrid-Kühlbauteils 13, 14 zusammen mit dem jeweiligen, jeweils mit ihm fest und fluiddicht verbundenen Grundkörper 18 bzw. 20 des jeweiligen Hybrid-Kühlbauteils 13 bzw. 14 einen Kühlfluidraum ganz oder begrenzt ihn mindestens teilweise nach außen hin bzw. bildet mit diesem Kühlfluidleitungen 19 der Kühleinrichtung 11.

Der Kühlkörper 16 des unteren Hybrid-Kühlbauteils 13 und die Kühlkörper 17a, 17b, 17c des oberen Hybrid-Kühlbauteils 14 weisen dabei jeweils durch parallele Kühlrippen 36 begrenzte, in den Kühlkörper 16, 17a, 17b, 17c eingebrachte Kühlfluidleitungsabschnitte 19a bzw. 19b der Kühlfluidleitungen 19 der Kühleinrichtung 11 auf.

In besonderer Weise erfolgt im Betrieb ausgehend von dem für die beiden Hybrid-Kühlbauteile 13, 14 gemeinsamen Zulauf 22 der Durchfluss von Kühlmedium durch das untere und das obere Hybrid-Kühlbauteil 13, 14, und zwar durch das untere Hybrid-Kühlbauteil 13 in einer Parallelströmung und durch das obere Hybrid-Kühlbauteil 14 in einer Reihenströmung.

Zu diesem Zweck weist das untere Hybrid-Kühlbauteil 13 drei voneinander räumlich getrennte, in Längsrichtung aufeinanderfolgende Kühlzonen 37 auf, die derart ausgebildet und mit dem gemeinsamen Zulauf 22 fluidleitend verbunden sind, dass die Kühlzonen 37 nacheinander in einer Reihenströmung von dem über den Zulauf 22 zugeführten Kühlmedium durchströmt werden. Jede dieser drei Kühlzonen 37 wird durch einen separaten Be-reich des Kühlkörpers 16 gebildet, in dem dieser die in den Kühlkörper 16 eingebrachten, durch die Kühlrippen 36 begrenzten Kühlfluidleitungsabschnitte 19a aufweist.

Das obere Hybrid-Kühlbauteil 14 weist jeweils (auch) drei voneinander räumlich in Längsrichtung aufeinanderfolgende, getrennte Kühlzonen 38 auf, die allerdings derart ausgebildet und mit dem Zulauf 22 fluidleitend verbunden sind, dass diese Kühlzonen 38 jeweils parallel in einer Parallelströmung von dem über den Zulauf 22 zugeführten Kühlmedium durchströmt werden. Jede dieser Kühlzonen 38 ist dabei gebildet durch jeweils einen Kühlbauteilabschnitt 14a, 14b, 14c des oberen Hybrid-Kühlbauteils 14. Insbesondere durch jeweils einen Bereich des jeweiligen Kühlkörpers 17a, 17b, 17c des jeweiligen Kühlbauteilabschnitts 14a, 14b, 14c, in dem dieser die durch die parallelen Kühlrippen 36 begrenzten, in den jeweiligen Kühlkörper 17a, 17b, 17c eingebrachten Kühlfluidleitungsabschnitte 19b aufweist.

Die Kühlzonen 37, 38 der Hybrid-Kühlbauteile 13, 14 sind dabei des Weiteren derart ausgebildet fluidleitend mit dem Zulauf 22 verbunden, dass der Kühlmedium-Volumenstrom durch die parallel von Kühlmedium durchströmten Kühlzonen 37 des unteren Hybrid-Kühlbauteils 13 mit zunehmender Entfernung der jeweiligen Kühlzone 37 von dem Zulauf 22 von Kühlzone 37 zu Kühlzone 37 größer wird.

Dies vor allem, um eine aufgrund der Kühlmedium-Reihenströmung in dem oberen Hybrid-Kühlbauteil 14 - mit zunehmender Entfernung der jeweiligen Kühlzone 38 des zweiten Hybrid-Kühlbauteils 14 von dem Zulauf 22 - von Kühlzone 38 zu Kühlzone 38 nachlassen-de Kühlleistung des zweiten Hybrid-Kühlbauteils 14 zu kompensieren.

Was den Grundkörper 20 des oberen Hybrid-Kühlbauteils 14 betrifft, so verfügt dieser des Weiteren über Kühlfluidleitungsabschnitte 19c (diese sind in den Grundkörper 20 integriert bzw. durch diesen gebildet) der Kühlfluidleitungen 19, die sich bis zu einer dem Aufnahmeraum 15 zugewandten (unteren) Seite erstrecken und dort jeweils unter Anschluss an die durch die Kühlrippen 36 begrenzten Kühlfluidleitungsabschnitte 19b des jeweiligen Kühlkörpers 17a, 17b, 17c nach unten hin durch den jeweiligen Kühlkörpers 17a, 17b, 17c fluiddicht verschlossen sind.

Der Grundkörper 18 des unteren Hybrid-Kühlbauteils 13 wiederum weist in ihn integrierte bzw. durch ihn gebildete Kühlfluidleitungsabschnitte 19d auf, die sich bis zu der dem Aufnahmeraum 15 zugewandten (oberen) Seite erstrecken und dort jeweils unter Anschluss an die durch die Kühlrippen 36 begrenzten Kühlfluidleitungsabschnitte 19a des Kühlkörpers 16 nach oben hin durch den Kühlkörper 16 fluiddicht verschlossen sind.

Auf der von dem Aufnahmeraum 15 abgewandten Seite des Grundkörpers 18 schließlich enden Kühlfluidleitungsabschnitte 19e, die dort anschließen an Kühlfluidleitungsabschnitte 19f eines weiteren plattenartigen, starren, fluiddicht mit dem Grundkörper 18 verbundenen Kühlkörpers 39 aus Metall oder einer Metalllegierung und die durch diesen weiteren Kühlkörper 39 nach unten hin verschlossen sind. An diesen weiteren Kühlkörper 39 können bei Bedarf zusätzliche zu kühlende Gegenstände angeordnet werden.

Was den Zulauf 22 und den Ablauf 23 der Kühleinrichtung 11 betrifft, so sind diese auf der von dem Aufnahmeraum 15 abgewandten Seite des Grundkörpers 18 angeordnet. Sie umfassen vorliegend durch den Grundkörper 18 gebildete Anschlussabschnitte 42a (je-weils stoffeinteilig mit ihm ausgebildet bzw. einstückig mit ihm verbunden) und separate, in die Anschlussabschnitte 42a eingesteckte Anschlussteile 42b.

Sämtliche beschriebenen Merkmale der vorstehend anhand der Zeichnungen erläuterten Ausführungsbeispiele sind im Übrigen nur beispielhaft zu verstehen und stellen keine Beschränkung des Gegenstandes der Erfindung dar.

## Patentansprüche

1. Kühleinrichtung zum Abführen von Wärme von zu kühlenden Gegenständen (12), wie etwa von Leistungselektronikmodulen, mit einem ersten Hybrid-Kühlbauteil (13), durch das Kühlfluid durchleitbar ist und das über einen fluiddicht mit einem Grundkörper aus Kunststoff des ersten Hybrid-Kühlbauteils (13) verbundenen Kühlkörper aus Metall oder einer Metalllegierung zur Anordnung an zu kühlenden Gegenständen (12) verfügt, und mit einem mit dem ersten Hybrid-Kühlbauteil (13) zweiten Hybrid-Kühlbauteil (14), durch das Kühlfluid leitbar ist und das mehrere Kühlbauteilabschnitte aufweist, die miteinander verbunden sind und über jeweils einen Kühlkörper aus Metall oder einer Metalllegierung zur Anordnung an zu kühlenden Gegenständen (12) verfügen, der mit einem Grundkörper aus Kunststoff des zweiten Hybrid-Kühlbauteils (14) fluiddicht verbunden ist, wobei die beiden Hybrid-Kühlbauteile (13, 14) unter Bildung eines zwischen ihnen angeordneten Aufnahmeraums für zu kühlende Gegenstände (12) mit Abstand zueinander positioniert und miteinander verbunden sind, wobei ein Rahmenteil (31) mit ihm verbundene elektrische Kontaktierungselemente (43) aufweist zur Kontaktierung von elektrischen Kontaktierungselementen (43) von zu kühlenden Gegenständen (12) und/oder von anderen elektronischen Bauteilen, wobei das elektrische Kontaktierungselement (43) einen ersten Verbindungsabschnitt (43a), mit dem es mit einem elektrischen Kontaktierungselement eines zu kühlenden Gegenstands verbindbar ist, und einen zweiten Verbindungsabschnitt (43b), mit dem das elektrische Kontaktierungselement (43) mit einem elektrischen Kontaktierungselement (41) eines anderen elektronischen Bauteils elektrisch leitend verbindbar ist, aufweist.

2. Kühleinrichtung gemäß Anspruch 1, **dadurch gekennzeichnet, dass** der Aufnahmeraum (15) durch das zwischen den beiden Hybrid-Kühlbauteilen (13, 14) angeordnete Rahmenteil (31) der Kühleinrichtung unterteilt ist in mehrere separate Teilaufnahmeräume für zu kühlende Gegenstände (12).

3. Kühleinrichtung gemäß einem oder mehreren der vorhergehenden Ansprüche, **dadurch gekennzeichnet, dass** sich benachbarte Teilaufnahmeräume dieselbe Querstrebe teilen beziehungsweise an einer Seite durch dieselbe, zwischen den benachbarten Teilaufnahmeräumen angeordnete Querstrebe begrenzt werden, und/oder dass jedes Verbindungsgelenk (24, 25) des zweiten Hybrid-Kühlbauteils (14) mit Abstand zu einer solchen Querstrebe ohne seitlichen Versatz neben dieser angeordnet ist und/oder dass jeder Kühlbauteilabschnitt des zweiten Hybrid-Kühlbauteils (14) jeweils einem Teilaufnahmeraum zugeordnet ist, in den der Kühlbauteilabschnitt mindestens teilweise eintaucht sowie eingepasst ist.

4. Kühleinrichtung gemäß einem oder mehreren der vorhergehenden Ansprüche, **dadurch gekennzeichnet, dass** das Rahmenteil (31) an dem ersten Hybrid-Bauteil befestigt ist.

5. Kühleinrichtung gemäß einem oder mehreren der vorhergehenden Ansprüche, **dadurch gekennzeichnet, dass** diese eine Spanneinrichtung (29) aufweist zum Verspannen des ersten Hybrid-Kühlbauteil (13) mit dem zweiten Hybrid-Kühlbauteil (14), sodass die Kühlkörper der Hybrid-Kühlbauteile (13, 14) jeweils durch die Spanneinrichtung (29) bewirkte Druckkräfte auf zwischen ihnen anordenbare, zu kühlende Gegenstände (12) aufbringen können, wobei die Spanneinrichtung (29) ein Federbauteil (33) umfasst, das an derjenigen Seite jedes Kühlbauteilabschnitts des zweiten Hybrid-Kühlbauteils (14) angeordnet ist und auf diese Druckkräfte in Richtung des ersten Hybrid-Kühlbauteils (13) aufbringt, die der Seite gegenüberliegt, an der jeweils der Kühlkörper des jeweiligen Kühlbauteilabschnitts angeordnet ist, und dass dieses Federbauteil (33) mit dem ersten Hybrid-Kühlbauteil (13) verspannt ist.

6. Kühleinrichtung gemäß Anspruch 5, **dadurch gekennzeichnet, dass** das Federbauteil (33) mehrere Federelemente aufweist, die federnd gegen die jeweilige vorgenannte Seite des Kühlbauteilabschnitts des zweiten Hybrid-Kühlbauteil (14) gedrückt sind oder drückbar sind.

7. Kühleinrichtung gemäß einem oder mehreren der vorhergehenden Ansprüche, **dadurch gekennzeichnet, dass** jeder Kühlkörper jedes Hybrid-Kühlbauteils (13, 14) eine Wärmeaufnahmefläche aufweist zur Anlage oder Anordnung an einem jeweiligen zu kühlenden Gegenstand.

8. Kühleinrichtung gemäß einem oder mehreren der vorhergehenden Ansprüche, **dadurch gekennzeichnet, dass** die Kühlkörper der Kühlkörperabschnitte des zweiten Hybrid-Kühlbauteils (14) derart gelenkig miteinander verbunden sind, dass die Wärmeaufnahmeflächen der Kühlkörper der Kühlkörperabschnitte des zweiten Hybrid-Kühlbauteils (14) in verschiedenen, mit Abstand zueinander verlaufenden Ebenen anordenbar sind.

9. Kühleinrichtung gemäß einem oder mehreren der vorhergehenden Ansprüche, **dadurch gekennzeichnet, dass** jeder Kühlkörper jedes Hybrid-Kühlbauteils (13, 14) mit dem mit ihm fest und fluiddicht, verbundenen Grundkörper einen Kühlfluidraum ganz oder teilweise umschließt oder nach außen hin begrenzt, und/oder dass der Kühlkörper des ersten Hybrid-Kühlbauteils (13) und/oder die Kühlkörper des zweiten Hybrid-Kühlbauteils (14) durch Kühlrippen (36) begrenzte, in den Kühlkörper eingebrachte Kühlfluidleitungsabschnitte aufweisen.

10. Kühleinrichtung gemäß einem oder mehreren der vorhergehenden Ansprüche, **dadurch gekennzeichnet, dass** das erste und/oder das zweite Hybrid-Kühlbauteil (14) jeweils mehrere, voneinander räumlich getrennte Kühlzonen aufweist, die mit einem Zulauf der Kühleinrichtung derart fluidleitend verbunden sind, dass die Kühlzonen des ersten Hybrid-Kühlbauteils (13) jeweils parallel in einer Parallelströmung von einem über den Zulauf zugeführten Kühlmedium durchströmt werden und/oder dass die Kühlzonen des zweiten Hybrid-Kühlbauteils (14) jeweils nacheinander in einer Reihenströmung von einem über den Zulauf zuführten Kühlmedium durchströmt werden.

11. Kühleinrichtung gemäß Anspruch 10, **dadurch gekennzeichnet, dass** jedem Kühlbauteilabschnitt des zweiten Hybrid-Kühlbauteils (14) eine eigene Kühlzone zugeordnet ist.

12. Kühleinrichtung gemäß einem oder mehreren der vorhergehenden Ansprüche, **dadurch gekennzeichnet, dass** jede der räumlich getrennten Kühlzonen des ersten Hybrid-Kühlbauteils (13) durch einen Bereich des Kühlkörpers desselben gebildet ist, in dem dieser durch Kühlrippen (36) begrenzte, in den Kühlkörper eingebrachte Kühlfluidleitungsabschnitte aufweist, und/oder dass die Kühlzonen des ersten und des zweiten Hybrid-Kühlbauteils (14) derart ausgebildet und fluidleitend mit dem Zulauf der Kühleinrichtung verbunden sind, dass der Kühlmedium-Volumenstrom durch die parallel von Kühlmedium durchströmbaren Kühlzonen des ersten Hybrid-Kühlbauteils (13) mit zunehmender Entfernung der jeweiligen Kühlzone von dem Zulauf der Kühleinrichtung von Kühlzone zu Kühlzone größer wird.

13. Kühleinrichtung gemäß einem oder mehreren der vorhergehenden Ansprüche, **dadurch gekennzeichnet, dass** die Kühlkörper der Kühlbauteilabschnitte des zweiten Hybrid-Kühlbauteils (14) jeweils mit einem gemeinsamen Grundkörper aus Kunststoff verbunden sind, der flexible als Hohlkörper ausgebildete Verbindungsabschnitte aufweist, die die Verbindungsgelenke (24, 25) zwischen benachbarten Kühlbauteilabschnitten des zweiten Hybrid-Kühlbauteils (14) bilden und diese fluidleitend miteinander verbinden, sodass durch sie Kühlmedium zwischen den benachbarten Kühlbauteilabschnitten fließen kann.

14. Kühleinrichtung gemäß einem oder mehreren der vorhergehenden Ansprüche, **dadurch gekennzeichnet, dass** der Grundkörper des zweiten Hybrid-Kühlbauteils (14) Fluidleitungsabschnitte des zweiten Hybrid-Kühlbauteils (14) aufweist, die auf einer dem Aufnahmeraum (15) zugewandten Seite jeweils durch die Kühlkörper des zweiten Hybrid-Kühlbauteils (14) fluiddicht verschlossen sind, und/oder dass der Grundkörper des ersten Hybrid-Kühlbauteils (13) Fluidleitungsabschnitte des ersten Hybrid-Kühlbauteils (13) aufweist, die auf einer dem Aufnahmeraum (15) zugewandten Seite durch den Kühlkörper des ersten Hybrid-Kühlbauteils (13) fluiddicht verschlossen sind.

15. Kühleinrichtung gemäß einem oder mehreren der vorhergehenden Ansprüche,, **dadurch gekennzeichnet, dass** der Grundkörper des ersten Hybrid-Kühlbauteils (13) Fluidleitungsabschnitte des ersten Hybrid-Kühlbauteils (13) aufweist, die auf der von dem Aufnahmeraum (15) abgewandten Seite durch einen weiteren, fluiddicht mit dem Grundkörper verbundenen Kühlkörper aus Metall oder einer Metalllegierung verschlossen sind, und/oder dass der Zulauf der Kühleinrichtung und/oder ein Ablauf der Kühleinrichtung, durch den Kühlmedium nach Durchströmen der Kühleinrichtung, abfließen kann, einen Abschnitt umfasst, der gebildet ist durch den Grundkörper des ersten Hybrid-Kühlbauteils (13), und/oder dass der Zulauf und/oder der Ablauf auf der von dem Aufnahmeraum (15) abgewandten Seite des Grundkörpers angeordnet ist.

16. Kühleinrichtung gemäß einem oder mehreren der vorhergehenden Ansprüche, **dadurch gekennzeichnet, dass** der oder jeder Grundkörper des ersten Hybrid-Kühlbauteils (13) und/oder der oder jeder Grundkörper des zweiten Hybrid-Kühlbauteils (14) ein Spritzgussteil aus Kunststoff ist, und/oder dass das jeweilige elektrische Kontaktierungselement (41) jeweils mit dem Rahmenteil (31) verbunden ist.

17. Kühleinrichtung gemäß einem oder mehreren der vorhergehenden Ansprüche, **dadurch gekennzeichnet, dass** das jeweilige elektrische Kontaktierungselement (43) in das Rahmenteil (31) unlösbar integriert ist, indem es mindestens bereichsweise von dem Spritzgusskunststoff des Rahmenteils umspritzt ist.

18. Kühleinrichtung gemäß einem oder mehreren der vorhergehenden Ansprüche, **dadurch gekennzeichnet, dass** der oder jeder Verbindungsabschnitt (43a, 43b) des jeweiligen elektrischen Kontaktierungselements (43) eine Press-Fit-Geometrie aufweist oder als Lötkontakt ausgebildet ist.

19. Kühleinrichtung gemäß einem oder mehreren der vorhergehenden Ansprüche, **dadurch gekennzeichnet, dass** das Rahmenteil mindestens eine einstückig mit ihm verbundene beziehungsweise stoffeinteilig mit dem Rahmenteil ausgebildete Positionierhilfen zur Positionierung eines elektronischen Bauteils aufweist.

20. Leistungselektronikeinheit mit einer Kühleinrichtung gemäß einem oder mehreren der vorhergehenden Ansprüche sowie mehreren Leistungselektronikbauteilen, die zur Kühlung derselben im Aufnahmeraum (15) der Kühleinrichtung angeordnet sind.

## Claims

1. A cooling device for dissipating heat from objects to be cooled (12), such as from power electronic modules, having a first hybrid cooling component (13) through which cooling fluid can be guided and which has a heat sink of metal or of a metal alloy, which is connected in a fluid-tight manner to a base body of plastics material of the first hybrid cooling component (13) and which is to be arranged on objects to be cooled (12), and having a second hybrid cooling component (14) which is connected to the first hybrid cooling component (13) and through which cooling fluid can be guided, and which has a plurality of cooling component portions that are connected to one another and each of which have a heat sink of metal or of a metal alloy, which is to be arranged on objects to be cooled (12), and which is connected in a fluid-tight manner to a base body of plastics material of the second hybrid cooling component (14), wherein the two hybrid cooling components (13, 14) are positioned at a distance from one another and are connected together with the formation of a reception space arranged between them for objects to be cooled (12), ,wherein a frame part (31) has electrical contacting elements (43) connected thereto for contacting electrical contacting elements (43) of the objects to be cooled (12) and/or of other electronic components, wherein the electrical contacting element (43) has a first connecting portion (43a), with which it can be connected to the electrical contacting element of a respective object to be cooled, and a second connecting portion (43b), with which the electrical contacting element (43) can be electrically conductively connected to an electrical contact element (41) of another electronic component.

2. The cooling device according to claim 1, **characterized in that** the reception space (15) is divided into a plurality of separate partial reception spaces for objects to be cooled (12) by means of a frame part (31) of the cooling device that is arranged between the two hybrid cooling components (13, 14).

3. The cooling device according to one or more of the preceding claims, **characterized in that** adjacent partial holding spaces share the same transverse members, or are delimited on one side by the same transverse member arranged between the adjacent partial holding spaces, and/or that each cooling component portion of the second hybrid cooling component (14) has an associated partial reception space into which the cooling component portion, has been inserted at least partially and also fitted.

4. The cooling device according to one or more of the preceding claims, **characterized in that** the frame part (31) is fastened to the first hybrid component.

5. The cooling device according to one or more of the preceding claims, **characterized in that** it has a clamping device (29) for clamping the first hybrid cooling component (13) to the second hybrid cooling component (14), so that the heat sinks of the hybrid cooling components (13, 14) are each able to apply pressure forces, effected by the clamping device (29), to objects to be cooled (12) which can be arranged between them, wherein the clamping device (29) comprises a spring component (33) which is arranged on, and applies pressure forces in the direction of the first hybrid cooling component (13) to the face of each cooling component portion of the second hybrid cooling component (14) that is situated opposite the face on which the heat sink of the cooling component portion is arranged, and wherein this spring component (33) is clamped to the first hybrid cooling component (13).

6. The cooling device according to claim 5, **characterized in that** the spring component (33) has a plurality of spring elements, which are pressed or can be pressed in a resilient manner against the above-mentioned face of the cooling component portion of the second hybrid cooling component (14).

7. The cooling device according to one or more of the preceding claims, **characterized in that** each heat sink of each hybrid cooling component (13, 14) has a heat absorption surface for contact with or arrangement on an object to be cooled.

8. The cooling device according to claim 7, **characterized in that** the heat sinks of the heat sink portions of the second hybrid cooling component (14) are connected in an articulated manner to one another, such that the heat absorption surfaces of the heat sinks of the heat sink portions of the second hybrid cooling component (14) can be arranged in different planes spaced apart from one another.

9. The cooling device according to one or more of the preceding claims, **characterized in that** each heat sink of each hybrid cooling component (13, 14), with the base body connected thereto in a fixed and fluid-tight manner, completely or partially encloses or delimits to the outside a cooling fluid space, and/or that the heat sink of the first hybrid cooling component (13) and/or the heat sinks of the second hybrid cooling component (14) have cooling fluid line portions which are delimited by cooling fins (36) and have been introduced into the heat sink.

10. The cooling device according to one or more of the preceding claims, **characterized in that** the first and/or the second hybrid cooling component (14) each has a plurality of cooling zones which are spatially separate from one another and which are connected in a fluid-conducting manner to a feed of the cooling device, in such a manner that a cooling medium supplied by way of the feed flows through each of the cooling zones of the first hybrid cooling component (13) in parallel in a parallel flow and/or that a cooling medium supplied by way of the feed flows through the cooling zones of the second hybrid cooling component (14) in succession in a serial flow.

11. The cooling device according to claim 10, **characterized in that** each cooling component portion of the second hybrid cooling component (14) has its own associated cooling zone.

12. The cooling device according to one or more of the preceding claims, **characterized in that** each of the spatially separate cooling zones of the first hybrid cooling component (13) is formed by a region of the heat sink thereof in which the heat sink has cooling fluid line portions introduced into the heat sink and delimited by cooling fins (36), and/or that the cooling zones of the first and of the second hybrid cooling component (14) are configured and connected in a fluid-conducting manner to the feed of the cooling device in such a manner that the cooling medium volume flow through the cooling zones of the first hybrid cooling component (13), through which cooling medium can flow in parallel, becomes greater from cooling zone to cooling zone as the distance of the cooling zone from the feed of the cooling device increases.

13. The cooling device according to one or more of the preceding claims, **characterized in that** the heat sink portions of the second hybrid cooling component (14) are connected in an articulated manner to one another via connecting joints (24, 25), wherein the heat sinks of the cooling component portions of the second hybrid cooling component (14) are each connected to a common base body of plastics material which has flexible connecting portions, formed as hollow bodies, which form the connecting joints (24, 25) between adjacent cooling component portions of the second hybrid cooling component (14) and connect them together in a fluid-conducting manner, so that cooling medium is able to flow through them between the adjacent cooling component portions.

14. The cooling device according to one or more of the preceding claims, **characterized in that** the base body of the second hybrid cooling component (14) has fluid line portions of the second hybrid cooling component (14) which are each closed in a fluid-tight manner on a side facing the reception space (15) by the heat sinks of the second hybrid cooling component (14) and/or that the base body of the first hybrid cooling component (13) has fluid line portions of the first hybrid cooling component (13) which are closed in a fluid-tight manner on a side facing the reception space (15) by the heat sink of the first hybrid cooling component (13).

15. The cooling device according to one or more of the preceding claims, **characterized in that** the base body of the first hybrid cooling component (13) has fluid line portions of the first hybrid cooling component (13) which are closed on the side remote from the reception space (15) by a further heat sink of metal or of a metal alloy which is connected in a fluid-tight manner to the base body, and/or that the feed of the cooling device and/or a drain of the cooling device, through which the cooling medium is able to flow away after it has flowed through the cooling device, comprises a portion which is formed by the base body of the first hybrid cooling component (13) and/or the feed and/or the drain is arranged on the side of the base body that is remote from the reception space (15).

16. The cooling device according to one or more of the preceding claims, **characterized in that** the or each base body of the first hybrid cooling component (13) and/or the or each base body of the second hybrid cooling component (14) is an injection-molded part of plastics material and/or that each electrical contacting element (41) is connected to the frame part (31).

17. The cooling device according to one or more of the preceding claims, **characterized in that** the electrical contacting element (43) is integrated non-releasably into the frame part (31) **in that** it is over molded at least in some regions by the injection-molded plastics material of the frame part.

18. The cooling device according to one or more of the preceding claims, **characterized in that** the or each connecting portion (43a, 43b) of the electrical contacting element (43) has a press-fit geometry or is configured as a solder contact.

19. The cooling device according to one or more of the preceding claims, **characterized in that** the frame part has at least one positioning aid connected thereto or integrally formed therewith for positioning an electronic component.

20. A power electronics unit having a cooling device according to one or more of the preceding claims and having a plurality of power electronics components which, for the cooling thereof, are arranged in the reception space (15) of the cooling device.

## Revendications

1. Dispositif de refroidissement destiné à évacuer la chaleur d'objets à refroidir (12), tels que des modules électroniques de puissance, comprenant un premier composant de refroidissement hybride (13), à travers lequel le fluide de refroidissement peut circuler et qui comporte un dissipateur thermique en métal ou en alliage métallique, relié de manière étanche aux fluides à un corps de base en plastique du premier composant de refroidissement hybride (13), destiné à être disposé sur des objets à refroidir (12), et comprenant un deuxième composant de refroidissement hybride (14) relié au premier composant de refroidissement hybride (13), à travers lequel le fluide de refroidissement peut circuler et qui comporte plusieurs sections de composant de refroidissement reliées entre elles et disposant chacune d'un dissipateur thermique en métal ou en alliage métallique destiné à être placé sur des objets à refroidir (12), lequel est relié de manière étanche aux fluides à un corps de base en plastique du deuxième composant de refroidissement hybride (14), les deux composants de refroidissement hybrides (13, 14) sont positionnés à distance l'un de l'autre et reliés entre eux en formant un espace de réception pour les objets à refroidir (12) disposé entre eux, une partie de cadre (31) comportant des éléments de contact électrique (43) qui lui sont reliés pour établir le contact avec des éléments de contact électrique (43) d'objets à refroidir (12) et/ou d'autres composants électroniques, l'élément de contact électrique (43) comportant une première partie de connexion (43a) permettant de le relier à un élément de contact électrique d'un objet à refroidir, et une deuxième partie de connexion (43b) permettant de relier de manière électriquement conductrice l'élément de contact électrique (43) à un élément de contact électrique (41) d'un autre composant électronique.

2. Dispositif de refroidissement selon la revendication 1, **caractérisé en ce que** l'espace de réception (15) est divisé en plusieurs espaces de réception partiels séparés pour des objets à refroidir (12) par la partie de cadre (31) du dispositif de refroidissement disposée entre les deux composants de refroidissement hybrides (13, 14).

3. Dispositif de refroidissement selon une ou plusieurs des revendications précédentes, **caractérisé en ce que** des espaces de réception partiels adjacents partagent la même traverse ou sont délimités sur un côté par la même traverse disposée entre les espaces de réception partiels adjacents, et/ou **en ce que** chaque section de composant de refroidissement du deuxième composant de refroidissement hybride (14) est associée à un espace de réception, dans lequel la section de composant de refroidissement est au moins partiellement immergée et ajustée.

4. Dispositif de refroidissement selon l'une ou plusieurs des revendications précédentes, **caractérisé en ce que** la partie de cadre (31) est fixé au premier composant hybride.

5. Dispositif de refroidissement selon l'une ou plusieurs des revendications précédentes, **caractérisé en ce que** qu'il comprend un dispositif de serrage (29) destiné à serrer le premier composant de refroidissement hybride (13) avec le deuxième composant de refroidissement hybride (14), de sorte que les dissipateurs thermiques des composants de refroidissement hybrides (13, 14) puissent exercer, par l'intermédiaire des forces de pression générées par le dispositif de serrage (29), une pression sur les objets à refroidir (12) pouvant être disposés entre eux, le dispositif de serrage (29) comprend un élément élastique (33) qui est disposé sur le côté de chaque section de composant de refroidissement du deuxième composant de refroidissement hybride (14) et qui exerce sur celle-ci des forces de pression en direction du premier composant de refroidissement hybride (13) qui est opposé au côté sur lequel est disposé le dissipateur thermique de la section de composant de refroidissement respective, et **en ce que** cet élément élastique (33) est serré contre le premier composant de refroidissement hybride (13).

6. Dispositif de refroidissement selon la revendication 5, **caractérisé en ce que** l'élément élastique (33) comporte plusieurs éléments élastiques qui sont pressés ou peuvent être pressés de manière élastique contre le côté respectif susmentionné de la partie de composant de refroidissement du deuxième composant de refroidissement hybride (14).

7. Dispositif de refroidissement selon une ou plusieurs des revendications précédentes, **caractérisé en ce que** chaque dissipateur thermique de chaque élément de refroidissement hybride (13, 14) comporte une surface d'absorption de chaleur destinée à être mise en contact ou disposée contre un objet respectif à refroidir.

8. Dispositif de refroidissement selon la revendication 7, **caractérisé en ce que** les dissipateurs thermiques des sections de dissipateurs thermiques du deuxième composant de refroidissement hybride (14) sont reliés entre eux de manière articulée de telle sorte que les surfaces d'absorption de chaleur des dissipateurs thermiques des sections de dissipateurs thermiques du deuxième composant de refroidissement hybride (14) puissent être disposées dans différents plans espacés les uns des autres.

9. Dispositif de refroidissement selon l'une ou plusieurs des revendications précédentes, **caractérisé en ce que** chaque dissipateur thermique de chaque composant de refroidissement hybride (13, 14) entoure entièrement ou partiellement, ou délimite vers l'extérieur, un espace de fluide de refroidissement avec le corps de base auquel il est relié de manière fixe et étanche aux fluides, et/ou **en ce que** le dissipateur thermique du premier élément de refroidissement hybride (13) et/ou les dissipateurs thermiques du deuxième élément de refroidissement hybride (14) comportent des sections de conduits de fluide de refroidissement délimitées par des ailettes de refroidissement (36) et intégrées dans le dissipateur thermique.

10. Dispositif de refroidissement selon l'une ou plusieurs des revendications précédentes, **caractérisé en ce que** le premier et/ou le deuxième composant de refroidissement hybride (14) comporte chacun plusieurs zones de refroidissement séparées spatialement les unes des autres, qui sont reliées de manière à permettre la circulation du fluide à une entrée du dispositif de refroidissement de telle sorte que les zones de refroidissement du premier composant de refroidissement hybride (13) sont traversées chacune en parallèle, dans un écoulement parallèle, par un fluide de refroidissement acheminé par l'entrée, et/ou que les zones de refroidissement du deuxième élément de refroidissement hybride (14) sont traversées chacune successivement, dans un écoulement en série, par un fluide de refroidissement acheminé par l'entrée.

11. Dispositif de refroidissement selon la revendication 10, **caractérisé en ce qu'**une zone de refroidissement distincte est associée à chaque section de l'élément de refroidissement hybride (14).

12. Dispositif de refroidissement selon une ou plusieurs des revendications précédentes, **caractérisé en ce que** chacune des zones de refroidissement spatialement séparées du premier élément de refroidissement hybride (13) est formée par une partie du dissipateur thermique de celui-ci, dans laquelle ce dernier comporte des sections de conduits de fluide de refroidissement délimitées par des ailettes de refroidissement (36) et intégrées dans le dissipateur thermique, et/ou **en ce que** les zones de refroidissement des premier et deuxième éléments de refroidissement hybrides (14) sont conçues et reliées de manière à permettre la circulation du fluide à l'entrée du dispositif de refroidissement de telle sorte que le débit volumique du fluide de refroidissement à travers les zones de refroidissement du premier élément de refroidissement hybride (13), qui peuvent être traversées en parallèle par le fluide de refroidissement, augmente d'une zone de refroidissement à l'autre à mesure que la distance de la zone de refroidissement respective par rapport à l'entrée du dispositif de refroidissement augmente.

13. Dispositif de refroidissement selon l'une ou plusieurs des revendications précédentes, **caractérisé en ce que** les sections de l'élément de refroidissement du deuxième élément de refroidissement hybride sont reliées entre elles de manière articulée par des articulations de liaison (24, 25), les dissipateurs thermiques des sections de l'élément de refroidissement du deuxième élément de refroidissement hybride (14) étant chacun reliés à un corps de base commun en plastique, qui comporte des sections de liaison flexibles conçues sous forme de corps creux, lesquelles forment les articulations de liaison (24, 25) entre des sections de composant de refroidissement adjacentes du deuxième composant de refroidissement hybride (14) et relient celles-ci entre elles de manière à permettre la circulation de fluide, de sorte que le fluide de refroidissement puisse s'écouler à travers elles entre les sections de composant de refroidissement adjacentes.

14. Dispositif de refroidissement selon l'une ou plusieurs des revendications précédentes, **caractérisé en ce que** le corps de base du deuxième élément de refroidissement hybride (14) comporte des sections de conduite de fluide du deuxième élément de refroidissement hybride (14) qui, sur un côté tourné vers l'espace de réception (15), sont chacune fermées de manière étanche aux fluides par les dissipateurs thermiques du deuxième élément de refroidissement hybride (14) et/ou **en ce que** le corps de base du premier composant de refroidissement hybride (13) comporte des sections de conduite de fluide du premier composant de refroidissement hybride (13) qui sont fermées de manière étanche au fluide, sur un côté tourné vers l'espace de réception (15), par le dissipateur thermique du premier composant de refroidissement hybride (13).

15. Dispositif de refroidissement selon l'une ou plusieurs des revendications précédentes, **caractérisé en ce que** le corps de base du premier composant de refroidissement hybride (13) comporte des sections de conduites de fluide du premier composant de refroidissement hybride (13) qui, du côté opposé à l'espace de réception (15), sont fermées de manière étanche aux fluides par un autre corps de refroidissement en métal ou en alliage métallique relié de manière étanche aux fluides au corps de base, et/ou **en ce que** l'entrée du dispositif de refroidissement et/ou une sortie du dispositif de refroidissement, par laquelle le fluide de refroidissement peut s'écouler après avoir traversé le dispositif de refroidissement, comprend une section formée par le corps de base du premier composant de refroidissement hybride (13), et/ou **en ce que** l'entrée et/ou la sortie est disposée sur le côté du corps de base opposé à l'espace de réception (15).

16. Dispositif de refroidissement selon une ou plusieurs des revendications précédentes, **caractérisé en ce que** le ou chaque corps de base du premier composant de refroidissement hybride (13) et/ou le ou chaque corps de base du deuxième composant de refroidissement hybride (14) est une pièce moulée par injection en plastique, et/ou **en ce que** l'élément de contact électrique respectif (41) est relié à la partie de cadre (31).

17. Dispositif de refroidissement selon l'une ou plusieurs des revendications précédentes, **caractérisé en ce que** l'élément de contact électrique respectif (43) est intégré de manière indétachable dans la partie de cadre (31) en étant surmoulé, au moins par endroits, par la matière plastique moulée par injection de la partie de cadre.

18. Dispositif de refroidissement selon l'une ou plusieurs des revendications précédentes, **caractérisé en ce que** la ou chaque section de connexion (43a, 43b) de l'élément de contact électrique correspondant (43) présente une géométrie à ajustement serré ou est réalisée sous forme de contact à souder.

19. Dispositif de refroidissement selon l'une ou plusieurs des revendications précédentes, **caractérisé en ce que** la partie de cadre comporte au moins un moyen d'aide au positionnement relié d'un seul tenant à celle-ci ou formé d'un seul tenant avec la partie de cadre, destiné au positionnement d'un composant électronique.

20. Unité électronique de puissance comprenant un dispositif de refroidissement selon l'une ou plusieurs des revendications précédentes, ainsi que plusieurs composants électroniques de puissance qui sont disposés dans l'espace de réception (15) du dispositif de refroidissement pour le refroidissement de ceux-ci.
